# EUROPEAN PATENT APPLICATION

(11) **EP 4 198 803 A1**
(43) Date of publication of application: **21.06.2023**
(21) Application number: 21857630.4
(22) Date of filing: 16.08.2021
(51) Int. Cl.: G06F 30/27

(54) **FAULT PROCESSING METHOD AND APPARATUS, NETWORK DEVICE AND STORAGE MEDIUM**

(30) Priority: 17.08.2020 CN 202010826217
(71) Applicant: ZTE Corporation, Shenzhen, Guangdong 518057 (CN)
(72) Inventor: YANG, Xikun, Shenzhen, Guangdong 518057 (CN); LUO, Qingkai, Shenzhen, Guangdong 518057 (CN)
(74) Representative: Ipsilon
(86) International application number: PCT/CN2021/112806
(87) International publication number: WO 2022/037536

(57) **Abstract**

The present disclosure provides a fault processing method, a fault processing apparatus, a network device and a storage medium, the method includes: according to types of optical modules, analyzing historical data of each optical module, and determining the historical data, which suddenly changes in response to a fault occurring, of the optical module; extracting corresponding original fault data from the historical data which suddenly changes; and performing fault model training according to the type of the optical module based on the original fault data.

## Description

### CROSS-REFERENCE TO RELATED APPLICATIONS

The present application claims the priority of Chinese Patent Application CN202010826217.3 filed on August 17, 2020, entitled "FAULT PROCESSING METHOD AND APPARATUS, NETWORK DEVICE AND STORAGE MEDIUM", the contents of which are incorporated herein in their entirety by reference.

### TECHNICAL FIELD

The present disclosure relates to, but not limited to, the field of optical network communication, and in particular, relates to, but not limited to, a fault processing method, a fault processing apparatus, a network device and a storage medium.

### BACKGROUND

With the continuous development of communication technology, in order to meet the requirements of the majority of users for broadband services such as integrated communication services, multimedia communication services and the like, the application of optical communication networks is becoming more and more extensive, and the appearance of the optical communication network well solves a bottleneck of bandwidth restriction of a transmission system in communication networks.

An optical module, serving as a key component for photoelectric signal conversion, is an important device for connecting an optical network. With continuous deployment of the optical network, more and more optical modules are used. Once a fault occurs in any optical module, it will directly affect the service quality and even cause service interruption. Although a rate of fault occurring of each optical module is relatively low, the number of optical modules existing in the current network is often hundreds of thousands or even millions, and thus the number of faults of the optical modules is still relatively large; moreover, the geographical distribution of each fault is random, operation and maintenance personnel are often unable to repair the fault in time, which brings very high operation and maintenance cost to the operator. Therefore, fault detection on the optical module becomes an essential means. However, in existing art, there are still some difficulties in fault detection on the optical module. Firstly, there are often differences between designs of optical modules from different manufacturers, resulting in differences between faults of the optical modules, and a unified detection method cannot cover all types of faults. In addition, current main detection methods each only use a single index, such as temperature, current, etc., and set certain thresholds for fault detection, the index is easily affected by the external environment, and thus detection effects obtained at different times by using a same set of thresholds may be greatly different. Therefore, in existing art, there is no universal fault detection solution for detecting faults of optical modules, which makes the operation and maintenance cost of the optical modules remain high.

### SUMMARY

The present disclosure provides a fault processing method, a fault processing apparatus, a network device and a storage medium, for solving at least one of technical problems of low universality of fault detection schemes for detecting faults of optical modules, and high operation and maintenance cost of the optical modules in existing art.

The present disclosure provides a fault processing method, including: analyzing historical data of each optical module according to a type of the optical module, and determining the historical data, which suddenly changes in response to a fault occurring, of the optical module; extracting corresponding original fault data from the historical data which suddenly changes; and based on the original fault data, performing fault model training to train a fault model according to the type of the optical module.

The present disclosure further provides a fault processing apparatus, including: a data analysis module, configured to analyze historical data of each optical module according to a type of the optical module and determine the historical data, which suddenly changes in response to a fault occurring, of the optical module; a fault extraction module, configured to extract corresponding original fault data from the historical data which suddenly changes; and a model training module, configured to perform fault model training to train a fault model according to the type of the optical module based on the original fault data.

The present disclosure further provides a network device, including: a processor, a memory, and a communication bus; the communication bus is connected between the processor and the memory for communication; the processor is configured to execute at least one computer program stored in the memory to implement the fault processing method as described above.

The present disclosure further provide a computer storage medium, storing at least one program thereon, the at least one program, executed by at least one processor, causes the at least one processor to implement the fault processing method as described above.

Additional features and corresponding advantages of the present disclosure are set forth in the following part of the description, and it is understood that at least part of the advantages become obvious from the description of the present disclosure.

### DESCRIPTION OF DRAWINGS

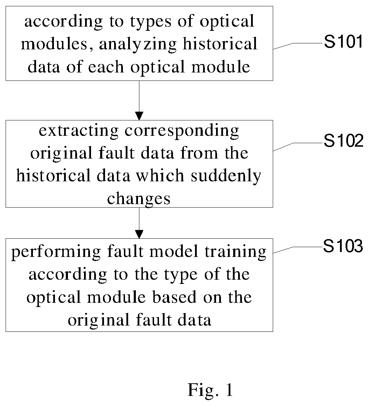

Fig. 1 is a flowchart of a fault processing method of the present disclosure;
Fig. 2 is a flowchart of a fault processing method of the present disclosure;
Fig. 3 is a deployment flowchart of a fault processing method of the present disclosure;
Fig. 4 is a flowchart of a fault processing method for detecting a fault of an optical module of the present disclosure;
Fig. 5 is a flowchart of monitoring and updating of a fault processing method of the present disclosure;
Fig. 6 is a schematic composition diagram of a fault processing apparatus of the present disclosure;
Fig. 7 is a schematic composition diagram of a fault processing system of the present disclosure; and
Fig. 8 is a schematic composition diagram of a network device of the present disclosure.

### DETAILED DESCRIPTION

In order to make the present disclosure more clearly understood, the following detailed description of the present disclosure is made with reference to the drawings. It should be understood that the specific implementations described here are only used to explain the present disclosure, not to limit the present disclosure.

### Exemplary Implementation 1

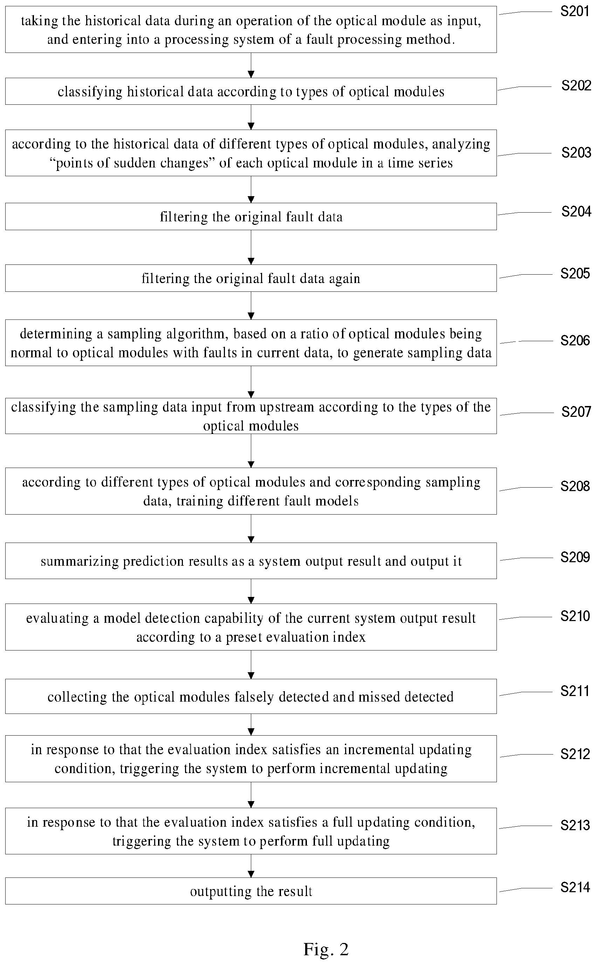

The present disclosure provides a fault processing method, and referring to Fig. 2, the method includes the following operations S101 to S103.

At S101, according to a type of each optical module, analyzing historical data of the optical module, and determining the historical data, which suddenly changes in response to a fault occurring, of the optical module.

At S102, extracting corresponding original fault data from the historical data which suddenly changes.

At S103, performing fault model training to train a fault model according to the type of the optical module based on the original fault data.

In order to make the fault processing method well be applicable to optical modules produced by various manufacturers, in this implementation, historical data of the optical module is analyzed according to the type of the optical module, that is, for different types of optical modules, different analysis results of the historical data of the optical modules may be obtained. The fault causes and fault effects of the optical modules may be similar, but changes of data of the optical modules during faults occurring may be different for the different types of the optical modules, bringing a difference of the historical data, which suddenly changes, of the optical modules in the analysis results of the historical data of the optical modules. In this implementation, the difference of the historical data which suddenly changes is considered, and an analysis is performed according to the type of the optical module, so as to obtain the historical data which suddenly changes during a fault occurring for each of different types of optical modules.

The historical data which suddenly changes indicates that the historical data changes significantly in a short period of time during the fault of the optical module occurring, and the historical data may be significantly increased or decreased. In fault detection on the optical module, it can be defined that "in the historical data of the optical module, at a certain time point, due to a special event (i.e., fault), some data around this time point changes significantly", the data that changes significantly here refers to the historical data which suddenly changes. Whether the data changes significantly here may be determined according to the actual data itself. For example, for a normal index, an increase or decrease thereof exceeding 50% in a short period of time indicates that the normal index (i.e., data) changes significantly. This implementation only lists one example to illustrate a range of data variation indicating that the data changes significantly. The range of data variation indicating that the data changes significantly may vary for different data, may be determined according to an actual system operation in combination with the type of the historical data, and is not limited in this implementation.

In addition, the data suddenly changing may also indicate that in a period after the time point of the fault until the optical module fails to work and is replaced, a characteristic trend of the data during this period is obviously different from that before the time point of the fault. For example, before a certain time point, the trend is always stable, and after the certain time point, the trend is rising, falling, or jittering, and in such case, the time point may be determined as a sudden change point at which the data suddenly changes, and an event that causes this sudden change point is relatively more likely to be a fault (i.e., the event is a fault with a relatively high probability).

During analyzing the situation of sudden changes of the historical data, indexes with most sudden changes are counted, and other historical data without sudden changes or with insignificant sudden changes may be directly ignored. Certainly, in order to improve the comprehensiveness of detection and avoid adverse consequences caused by missed and misjudged, the historical data without sudden changes or with insignificant sudden changes may be retained, for updating fault models in a subsequent updating stage.

The type of historical data of the optical module in the implementation may be performance data, inspection data, or the like. Before analyzing the historical data of each optical module according to the type of the optical module, optical modules may be classified according to types of the optical modules. Various types of optical modules may be classified directly according to manufacturers of the optical modules, or may be classified according to working principles of the optical modules, or according to specifications, application scopes of the optical modules, or the like.

The historical data which suddenly changes may be not all related to faults, that is, the historical data which suddenly changes is not necessarily referred to as fault data. For example, for a same type of optical modules, there may be some historical data which suddenly but accidentally changes, which only results in few optical modules with faults, then such data should not be regarded to be related to faults (i.e., not referred to as fault data); in other words, the fault data should be those historical data with a relatively high ratio of sudden changes during a fault occurring for a corresponding type of optical modules. The historical data with a relatively high ratio of sudden changes during a fault occurring for a corresponding type of optical modules may be used as original fault data. In the implementation, the extracting corresponding original fault data from the historical data which suddenly changes may include: analyzing time points of sudden changes in a time series according to the historical data which suddenly changes; according to the time points of sudden changes, determining the historical data with a ratio of sudden changes exceeding a preset ratio; taking the historical data with the ratio of sudden changes exceeding the preset ratio as the original fault data.

This scheme of determining the original fault data can greatly exclude those historical data with accidentally sudden changes, while retaining the historical data relatively more likely to be related to the fault (i.e., the historical data related to the fault with a high probability). Then, time points of sudden changes are analyzed, the time points of sudden changes may be considered as time points at which faults occur in the optical modules. At these time points, the historical data which suddenly changes is relatively concentrated; however, the historical data which suddenly changes at the time points of sudden changes may be not all caused by faults, so it can be filtered again, and the historical data with the ratio of sudden changes exceeding the preset ratio may be used as the original fault data. The ratio of sudden changes exceeding the preset ratio means that, at the time points of sudden changes, a ratio of sudden changes of the historical data exceeds a threshold. For example, at a certain time point of sudden changes, for multiple optical modules of a same type with faults, a ratio of sudden changes of certain historical data exceeds a certain ratio (for example, 80%), then the certain historical data may be considered as the original fault data. Alternatively, for any one optical module, it may have multiple time points of sudden changes, and at these time points of sudden changes, if a ratio of sudden changes of certain historical data exceeds a certain ratio (for example, 80%), the certain historical data may also be considered as the original fault data. For the implementation, since the processing method is to classify the optical modules according to the types, the original fault data determined for different types of optical modules will also be different, which proves differences of devices of different manufacturers on one hand, and shows an excellent universality of the fault processing method of the present disclosure on the other hand.

After the original fault data is determined, fault model training may be performed according to the type of the optical module based on the original fault data. Similarly, different fault models are trained for different types of optical modules.

In some implementations, the performing fault model training to train a fault model according to the type of the optical module based on the original fault data may include: filtering the original fault data to obtain target fault data; sampling the target fault data according to a normal-to-fault ratio of optical modules (i.e., a ratio of optical modules being normal to optical modules with faults) to obtain sampling data; and performing model training according to the sampling data.

Although the original fault data may be directly used for fault model training for optical modules, there may be some abnormalities, for example, gaps, abnormal data or the like may exist during analyzing the historical data, or non-fault related data may still exist in the original fault data obtained from the historical data which suddenly changes. Therefore, the original fault data may be filtered again to obtain the target fault data. The target fault data has a higher correlation with faults of optical modules, and the target fault data may reflect a fault condition of the optical modules to a greater extent, and the faults of the optical modules can be more accurately detected and analyzed.

In an actual system, the probability of faults of the optical modules is relatively low, and most of the optical modules do not have faults. Therefore, the target fault data may be sampled according to the normal-to-fault ratio of the optical modules to obtain sampling data. Then, the model training is performed according to the sampling data.

In some implementations, the filtering the original fault data includes: deleting abnormal data in the original fault data; and/or extracting data representing a timing characteristic of the optical module from the original fault data. The abnormal data mainly refers to missing data in a collection process, or the data with obvious errors; the data representing the timing characteristic of the optical module refers to data that, extracted for a characteristic of timing of the optical module, represents a significant characteristic in time.

In some implementations, the performing fault model training to train a fault model according to the type of the optical module may include: performing fault model training for different types of optical modules respectively, according to sampling data corresponding to the different types of optical modules. Different types of optical modules with faults correspond to different fault data and different fault models.

In some implementations, the fault model may include at least one of a machine learning model, a statistical model, or a deep learning model.

In some implementations, after performing the fault model training according to the type of the optical module, the method may further include: outputting a prediction result of fault risk of the optical module within a preset time according to a result of the fault model training. The result of the fault model training may be directly used for prediction, that is, to predict whether certain optical modules have faults, or when and what kinds of faults will occur in the optical modules, or the like, so as to facilitate the operation and maintenance of the system.

In some implementations, the method may further include: evaluating the prediction result of fault risk through a preset evaluation index. The prediction based on the result of fault model training may have a deviation, and thus the prediction result may be monitored by setting an evaluation index; an actual fault condition may be cross-compared with the prediction result to obtain the evaluation index corresponding to the corresponding fault model. Then, once the evaluation index triggers a condition, the fault model is to be updated.

In some implementations, the method may further include: collecting supplementary historical data corresponding to the optical module falsely detected or missed detected; and in response to that the preset evaluation index reaches an updating threshold, updating the fault model according to the supplementary historical data.

During analyzing the historical data of each optical module, the optical module actually normal may be mistaken as an optical module with a fault, that is, the optical module may be falsely detected, a false detection may occur, or the historical data of the optical module with the fault may be missed, that is, the optical module may be missed detected, a missed detection may occur; the missed detection and/or the false detection may also occur during predicting the fault condition of the optical module; and in response to the missed detection or the false detection occurring, the data of the missed detection or the false detection, i.e., the supplementary historical data, may be first collected, and in response to that the evaluation index reaches the updating threshold, the fault model may be updated according to the supplementary historical data.

The fault processing method provided in the present disclosure analyzes the historical data of each optical module according to the type of the optical module, and determines the historical data which suddenly changes in response to a fault occurring in optical modules of the type; from the historical data which suddenly changes, extracts the corresponding original fault data; performs fault model training according to the type of the optical module based on the original fault data. Therefore, according to types of optical modules, a flexibility of collecting historical data of optical modules with faults is improved, then the application scope of fault detection is improved, and the operation and maintenance cost for the optical modules is effectively reduced.

### Exemplary Implementation 2

Referring to Fig. 2, the present disclosure provides a fault processing method, which includes the following operations S201 to S214. At S201, taking the historical data (such as performance data, inspection data, etc.) during an operation of each optical module as an input, and entering into a processing system of the fault processing method.

At S202, classifying historical data according to types of optical modules, so as to obtain the historical data corresponding to each optical module, which is distinguished from other historical data according to the types of the optical modules.

At S203, for the historical data of different types of optical modules, analyzing "points of sudden changes" of each optical module in a time series, that is, determining time points at which faults occur, and obtaining the historical data, with a ratio of sudden changes reaches a certain ratio, of the optical module with a fault, as the original fault data.

At S204, filtering the original fault data, removing unnecessary data, and removing incorrectly collected data.

At S205, filtering the original fault data again, and extracting data representing a timing characteristic of the optical module as target fault data.

At S206, determining a sampling algorithm, based on a ratio of optical modules being normal to optical modules with faults in current data, so as to generate sampling data.

At S207, classifying the sampling data input from upstream according to the types of the optical modules, so as to obtain the sampling data corresponding to each corresponding type of optical modules.

At S208, according to different types of optical modules and corresponding sampling data, training different fault models. The fault model may be a machine learning model, or may be a statistical model or a deep learning model as desired or according to computing power; the fault model may be directly used in a prediction stage for outputting prediction results.

At S209, summarizing the prediction results as a system output result and outputting the system output result.

At S210, evaluating a model detection capability by evaluating the current system output result according to a preset evaluation index.

At S211, collecting data of optical modules falsely detected (optical modules being normal are detected as optical modules with faults) and missed detected (optical modules with faults are detected as normal), for subsequent updating the fault model.

At S212, in response to that the evaluation index satisfies an incremental updating condition, triggering the system to perform incremental updating.

At S213, in response to that the evaluation index satisfies a full updating condition, triggering the system to perform full updating.

At S214, outputting an output result for a user directly viewing, or outputting the output result to another downstream docking system.

### Exemplary Implementation 3

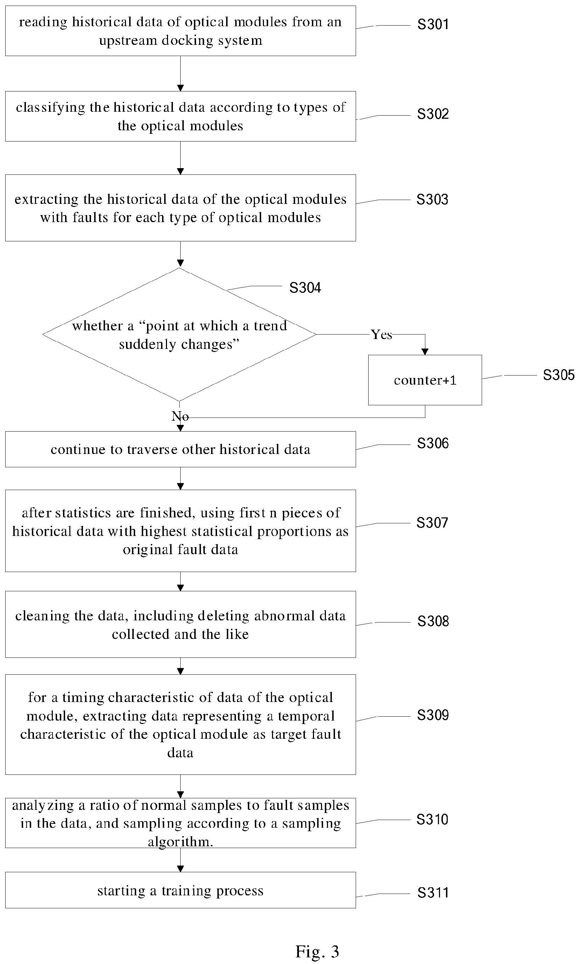

The present disclosure provides a deployment process of a fault processing method, referring to Fig. 3, the method includes the following operations S301 to S311.

At S301, reading historical data (such as performance data or inspection data) of optical modules from an upstream docking system.

At S302, classifying the historical data according to types of the optical modules.

At S303, extracting the historical data of the optical modules with faults for each type of optical modules.

At S304, analyzing the historical data of each optical module, and analyzing whether the historical data has a "point at which a trend suddenly changes".

At S305, in response to the point at which the trend suddenly changes existing, accumulating one to a statistic counter.

At S306, in response to no point at which a trend suddenly changes, continue to traverse other historical data until all historical data is analyzed.

At S307, after statistics are finished, using first n pieces of historical data with highest statistical ratios as original fault data.

At S308, cleaning the data, including deleting abnormal data collected and the like.

At S309, for a timing characteristic of data of the optical module, extracting the data representing a temporal characteristic (i.e., characteristic in time) of the optical module as target fault data.

At S310, analyzing a ratio of normal samples to fault samples in the data, and sampling according to a sampling algorithm.

At S311, starting a training process, training fault models according to the data of different types of optical modules respectively, and after the training is completed, a deployment process is completed.

### Exemplary Implementation 4

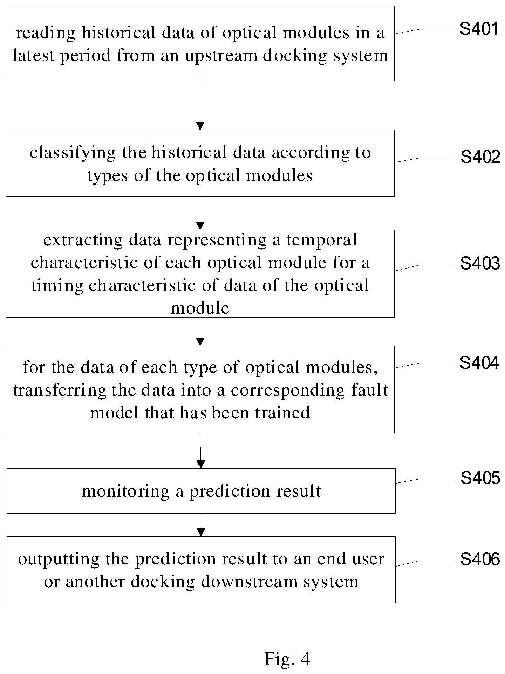

The present disclosure provides a process for detecting a fault of an optical module in a fault processing method, referring to Fig. 4, the process includes the following operations S401 to S406.

At S401, periodically running a fault detection task, and reading historical data of each optical module in a latest period from an upstream docking system.

At S402, classifying the historical data according to types of optical modules.

At S403, extracting data representing a temporal characteristic (i.e., characteristic in time) of each optical module for a timing characteristic of data of the optical module.

At S404, for the data of each type of optical modules, transferring the data into a corresponding fault model that has been trained, and outputting a probability of fault.

### At S405, monitoring a prediction result.

At S406, outputting the prediction result to an end user or another docking downstream system.

### Exemplary Implementation 5

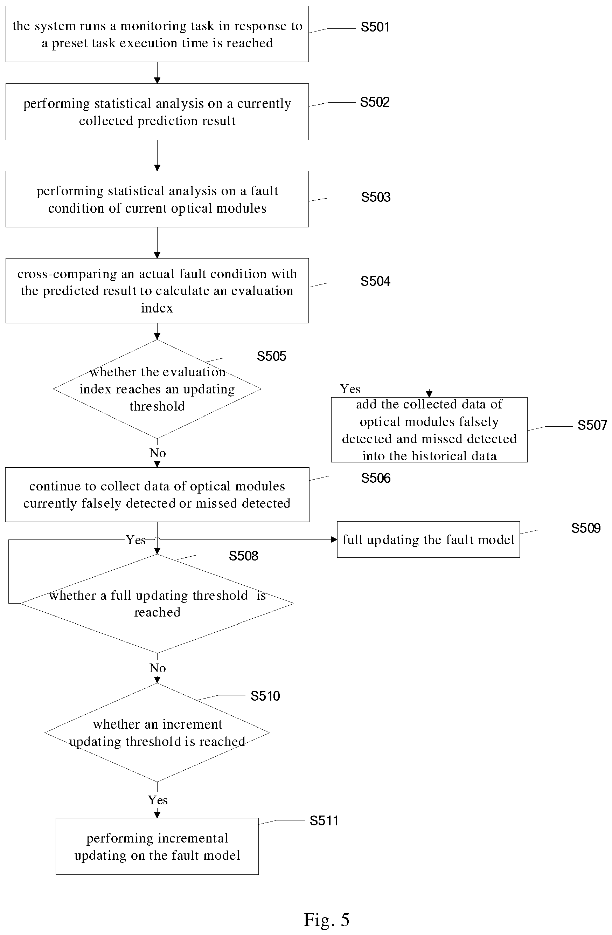

The present disclosure provides a monitoring and updating process of a fault processing method, referring to Fig. 5, the process includes the following operations S501 to S511.

At S501, a system runs a monitoring task in response to that a preset task execution time is reached.

At S502, performing statistical analysis on a currently collected prediction result.

At S503, performing statistical analysis on a current fault condition of optical modules, including whether there is a serious alarm, whether any optical module has been replaced, whether there is a maintenance work order, and the like.

At S504, cross-comparing an actual fault condition with the predicted result to calculate an evaluation index.

At S505, determining whether the evaluation index reaches an updating threshold (a full updating threshold for full updating or an incremental updating threshold for incremental updating).

At S506, in response to that the updating threshold is not reached, continue to collect data of optical modules currently falsely detected or missed detected.

At S507, in response to that the updating threshold is reached, preparing current historical data, and add the collected data of the optical modules falsely detected and missed detected into the historical data.

### At S508, determining whether the full updating threshold is reached.

At S509, in response to that the full updating threshold is reached, performing full updating on the fault model by using the data in the S507.

At S510, in response to that the full updating threshold is not reached, determining whether the increment updating threshold is reached.

At S511, in response to that the increment updating threshold is reached, performing incremental updating on the fault model by using the data in the S507.

### Exemplary Implementation 6

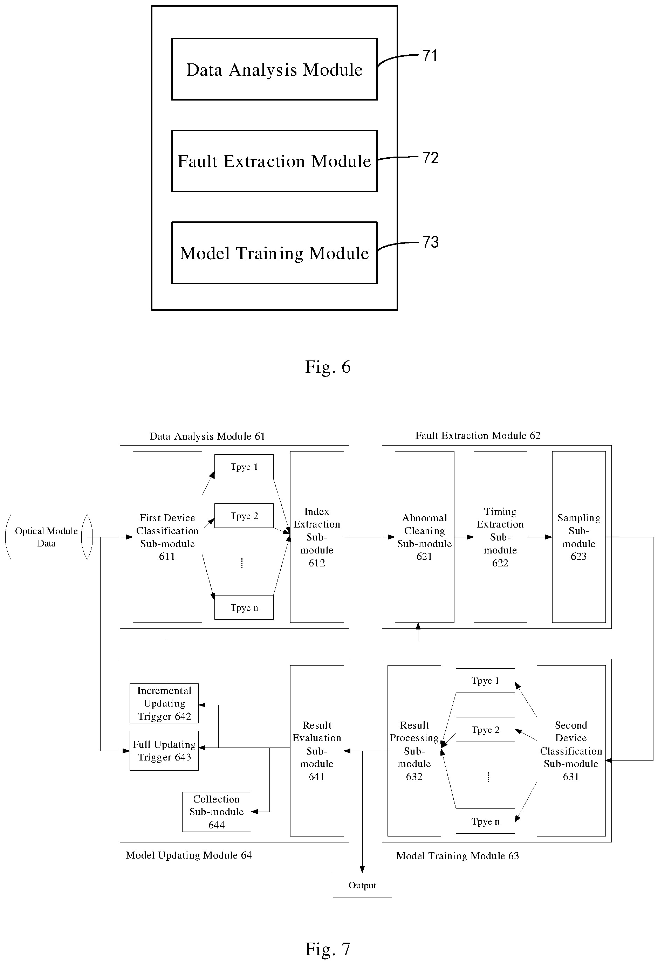

The present disclosure provides a fault processing apparatus, and referring to Fig. 6, the apparatus includes a data analysis module 61, a fault extraction module 62 and a model training module 63. The data analysis module 61 is configured to analyze historical data of each optical module according to a type of the optical module, and determine the historical data, which suddenly changes in response to a fault occurring, of the optical module. The fault extraction module 62 is configured to extract corresponding original fault data from the historical data which suddenly changes. The model training module 63 is configured to perform fault model training to train a fault model according to the type of the optical module based on the original fault data.

In order to make the fault processing apparatus well be applied to optical modules produced by various manufacturers, in this implementation, historical data of the optical module is analyzed according to the type of the optical module, that is, for different types of optical modules, different analysis results of the historical data of the optical modules may be obtained. The fault causes and fault effects of the optical modules may be similar, but changes of data of the optical modules during faults occurring may be different for the different types of the optical modules, bringing a difference of the historical data, which suddenly changes, of the optical modules in the analysis results of the historical data of the optical modules. In this implementation, the difference of the historical data which suddenly changes is considered, and an analysis is performed according to the type of the optical module, so as to obtain the historical data which suddenly changes during a fault occurring for each of different types of optical modules.

The historical data which suddenly changes indicates that the historical data changes significantly in a short period of time during the fault of the optical module occuring, and the historical data may be significantly increased or decreased. In fault detection on the optical module, it can be defined that "in the historical data of the optical module, at a certain time point, due to a special event (i.e., fault), some data around this time point changes significantly", the data that changes significantly here refers to the historical data which suddenly changes. Whether the data changes significantly here may be determined according to the actual data itself. For example, for a normal index, an increase or decrease thereof exceeding 50% in a short period of time indicates that the normal index (i.e., data) changes significantly. This implementation only lists one example to illustrate a range of data variation indicating that the data changes significantly. The range of data variation indicating that the data changes significantly may vary for different data, may be determined according to an actual system operation in combination with the type of the historical data, and is not limited in this implementation.

During analyzing the situation of sudden changes of the historical data, indexes with most sudden changes are counted, and other historical data without sudden changes or with insignificant sudden changes may be directly ignored. Certainly, in order to improve the comprehensiveness of detection and avoid adverse consequences caused by missed and misjudged, the historical data without sudden changes or with insignificant sudden changes may be retained, for updating fault models in a subsequent updating stage.

The type of historical data of the optical module in the implementation may be performance data, inspection data, or the like. Before analyzing the historical data of each optical module according to the type of the optical module, optical modules may be classified according to types of the optical modules. Various types of optical modules may be classified directly according to manufacturers of the optical modules, or may be classified according to working principles of the optical modules, or according to specifications, application scopes of the optical modules, or the like.

The historical data which suddenly changes may be not all related to faults, that is, the historical data which suddenly changes is not necessarily referred to as fault data. For example, for a same type of optical modules, there may be some historical data which suddenly but accidentally changes, which only results in few optical modules with faults, then such data should not be regarded to be related to faults (i.e., not referred to as fault data); in other words, the fault data should be those historical data with a relatively high ratio of sudden changes during a fault occurring for a corresponding type of optical modules. The historical data with a relatively high ratio of sudden changes during a fault occurring for a corresponding type of optical modules may be used as original fault data. In the implementation, extracting corresponding original fault data from the historical data which suddenly changes may include: analyzing time points of sudden changes in a time series according to the historical data which suddenly changes; according to the time points of sudden changes, determining the historical data with a ratio of sudden changes exceeding a preset ratios; taking the historical data with the ratio of sudden changes exceeding the preset ratio as the original fault data. This scheme of determining the original fault data can greatly exclude those historical data with accidentally sudden changes, while retaining the historical data related to the fault with a high probability. Then, time points of sudden changes are analyzed, the time points of sudden changes may be considered as time points at which faults occur in the optical modules. At these time points, the historical data which suddenly changes is relatively concentrated; however, the historical data which suddenly changes at the time points of sudden changes may be not all caused by faults, so it can be filtered again, and the historical data with the ratio of sudden changes exceeding the preset ratio may be used as the original fault data. The ratio of sudden changes exceeding the preset ratio means that, at the time points of sudden changes, a ratio of sudden changes of the historical data exceeds a threshold. For example, at a certain time point of sudden changes, for multiple optical modules of a same type with faults, a ratio of sudden changes of certain historical data exceeds a certain ratio (for example, 80%), then the ceratin historical data may be considered as the original fault data. Alternatively, for any one optical module, it may have multiple time points of sudden changes, and at these time points of sudden changes, if a ratio of sudden changes of certain historical data exceeds a certain ratio (for example, 80%), the certain historical data may also be considered as the original fault data. For the implementation, since the processing method is to classify the optical modules according to the types, the original fault data determined for different types of optical modules will also be different, which proves differences of devices of different manufacturers on one hand, and shows an excellent universality of the fault processing method of the present disclosure on the other hand.

After the original fault data is determined, fault model training may be performed according to the type of the optical module according to the original fault data. Similarly, different fault models are trained for different types of optical modules.

In some implementations, performing fault model training to train a fault model according to the type of the optical module based on the original fault data may include: filtering the original fault data to obtain target fault data; sampling the target fault data according to a normal-to-fault ratio of optical modules (i.e., a ratio of optical modules being normal to optical modules with faults) to obtain sampling data; and performing model training according to the sampling data. Although the original fault data may be directly used for fault model training for optical modules, there may be some abnormalities, for example, gaps, abnormal data or the like may exist during analyzing the historical data, or non-fault related data may still exist in the original fault data obtained from the historical data which suddenly changes. Therefore, the original fault data may be filtered again to obtain the target fault data. The target fault data has a higher correlation with faults of optical modules, and the target fault data may reflect a fault condition of the optical modules to a greater extent, and the faults of the optical modules can be more accurately detected and analyzed.

In an actual system, the probability of faults of the optical modules is relatively low, and most of the optical modules do not have faults. Therefore, the target fault data may be sampled according to the normal-to-fault ratio of the optical modules to obtain sampling data. Then, the model training is performed according to the sampling data.

In some implementations, filtering the original fault data includes: deleting abnormal data in the original fault data; and/or extracting data representing a timing characteristic of the optical module from the original fault data. The data representing the timing characteristic of the optical module refers to data that, extracted for a characteristic of timing of the optical module, represents a significant characteristic in time.

In some implementations, performing fault model training to train a fault model according to the type of the optical module may include: performing fault model training for different types of optical modules respectively, according to the sampling data corresponding to the different types of optical modules. Different types of optical modules with faults correspond to different fault data and different fault models.

In some implementations, the fault model may include at least one of a machine learning model, a statistical model, or a deep learning model.

In some implementations, after performing the fault model training according to the type of the optical module, the apparatus may further be configured to: output a prediction result of fault risk of the optical module within a preset time according to a result of fault model training. The result of the fault model training may be directly used for prediction, that is, to predict whether certain optical modules have faults, or when and what kinds of faults will occur in the optical modules, or the like, so as to facilitate the operation and maintenance of the system.

In some implementations, the apparatus may further be configured to: evaluate the prediction result of fault risk by using a preset evaluation index. The prediction based on the result of the fault model training may have a deviation, and thus the prediction result may be monitored by setting an evaluation index; an actual fault condition may be cross-compared with the prediction result to obtain the evaluation index corresponding to the corresponding fault model. Then, once the evaluation index triggers a condition, the fault model is to be updated.

In some implementations, the apparatus may further be configured to: collect supplementary historical data corresponding to falsely detected or missed detected optical modules; and in response to that the preset evaluation index reaches an updating threshold, updating the fault model according to the supplementary historical data. During analyzing the historical data of each optical module, the optical module actually normal may be mistaken as an optical module with a fault, that is, the optical module may be falsely detected, a false detection may occur, or the historical data of the optical module with the fault may be missed, that is, the optical module may be missed detected, a missed detection may occur; the missed detection and/or the false detection may also occur during predicting the fault condition of the optical module; and in response to the missed detection or the false detection occurring, the data of the missed detection or the false detection, i.e., the supplementary historical data, may be first collected, and in response to that the evaluation index reaches the updating threshold, the fault model may be updated according to the supplementary historical data.

By utilizing the data analysis module, the fault extraction module and the model training module which are included in the fault processing apparatus provided by the present disclosure, according to types of optical modules, a flexibility of collecting historical data of optical modules with faults is improved, and then the application scope of fault detection is improved, and the operation and maintenance cost for the optical modules is effectively reduced.

Referring to Fig. 7 , which shows a schematic composition diagram of a fault processing apparatus in a fault processing system of the present disclosure.

A data analysis module 61 is mainly responsible for classifying data, and extracting fault data indexes for different types of optical modules through an analysis algorithm for analyzing points of sudden changes; the data analysis module 61 includes a first device classification sub-module 611 and an index extraction sub-module 612, the first device classification sub-module 611 is mainly responsible for classifying data according to the types of the optical modules; the index extraction sub-module 612 analyzes the "points of sudden changes" in a time series for the fault data of different types of optical modules, and obtains the historical data with a relatively high ratio of sudden changes in the optical module with a fault, as the original fault data to be input to downstream.

A fault extraction module 62 is mainly responsible for simplifying data according to the original fault data provided by an upstream subsystem, cleaning abnormal data, extracting a new feature, and sampling data; the fault extraction module 62 includes an abnormal cleaning sub-module 621, a timing extraction sub-module 622 and a sampling sub-module 623, the abnormal cleaning sub-module 621 uses the original fault data extracted from the upstream, removes unnecessary data, and removes incorrectly collected data; the timing extraction sub-module 622 extracts data representing a significant characteristic in time for a characteristic of timing of the optical module; the sampling sub-module 623 formulates a sampling algorithm according to the ratio of optical modules being normal to optical modules with faults in current data, generates sampling data and transmits the sampling data to downstream.

A model training module 63 is mainly responsible for training a fault detection model and completing subsequent prediction tasks; the model training module 63 includes a second device classification sub-module 631 and a result processing sub-module 632, the second device classification sub-module 631 classifies sampling data input from upstream according to the types of the optical modules; and trains different models according to different types of optical modules and input data, and the model may include a machine learning model, or may include a statistical model or a deep learning model as desired or according to computing power; and in a prediction stage, results may be directly output by the model; the result processing sub-module 632 is configured to summarize the results as a system output result, and transmit the system output result to the downstream.

A model updating module 64 is mainly responsible for monitoring results output from upstream, and triggers an update of a system model in response to that an evaluation index drops; the model updating module 64 includes a result evaluation sub-module 641, a collection sub-module 644, an incremental updating trigger 642 and a full updating trigger 643, the result evaluation sub-module 641 is configured to evaluate a model detection capability by evaluating the current system output result through the evaluation index; the collection sub-module 644 is configured to detect data of optical modules falsely detected (that is, optical modules being normal are detected as optical modules with faults) and missed detected (that is, optical modules with faults are detected as normal) for subsequent updating the model; the incremental updating trigger 642, controlled by the result evaluation sub-module 641, triggers the system to perform incremental updating; the full update trigger 643, also controlled by the result evaluation sub-module 641, triggers the system to perform full updating.

The model updating module 64 may also output the results directly to a user.

### Exemplary Implementation 7

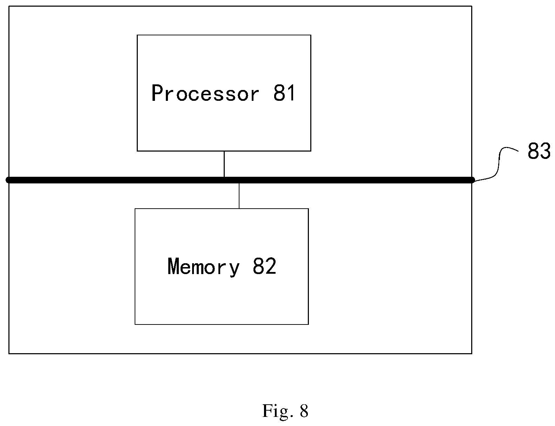

Referring to Fig. 8, the present disclosure further provides a network device, which includes a processor 81, a memory 82 and a communication bus 83; the communication bus 83 is connected between the processor 81 and the memory 82 for communication; the processor 81 is configured to execute at least one computer program stored in the memory 82 to implement the operations in the fault processing method in the above-described implementations, which are not described herein again.

The present disclosure further provides a computer-readable storage medium including volatile or non-volatile, removable or non-removable medium implemented in any method or technology for storage of information such as computer-readable instructions, data structures, computer program modules or other data. The computer-readable storage medium includes, but is not limited to, RAM (Random Access Memory), ROM (Read-Only Memory), EEPROM (Electrically Erasable Programmable Read-Only Memory), flash Memory or Memory in other technologies, CD-ROM (Compact disk Read-Only Memory), Digital Versatile Disks (DVD) or other optical disk storage, magnetic cassettes, magnetic tape, magnetic disk storage or other magnetic storage devices, or any other medium that can be configured to store desired information and can be accessed by a computer.

The computer-readable storage medium in the implementation may be configured to store at least one computer program, and the stored at least one computer program, executed by at least one processor, causes the at least one processor to implement the operations of the fault processing method in the above-described implementations.

The present disclosure further provides a computer program (or computer software), which can be distributed on a computer readable medium, and executed by a computing device to cause the computing device to implement the operations of the fault processing method in the above-described implementations; and in some cases at least one of the operations shown or described may be performed in an order different than the above-described implementations.

The present disclosure further provides a computer program product including a computer readable apparatus having a computer program stored thereon as described above. The computer readable apparatus in this implementation may include a computer readable storage medium as described above.

According to the fault processing method, the fault processing apparatus, the network device and the storage medium, the historical data of each optical module is analyzed according to the type of the optical module, the historical data which suddenly changes is determined in response to a fault occurring in optical modules of the type, the original fault data is extracted from the historical data which suddenly changes, and fault model training is performed according to the type of the optical module based on the original fault data. Therefore, according to types of optical modules, a flexibility of collecting historical data of optical modules with faults is improved, and then the application scope of fault detection is improved, and in an actual usage, the model can be automatically updated, and with an accumulation of fault data, the detection accuracy is continuously improved and the operation and maintenance cost for the optical modules is effectively reduced.

It will be apparent to those skilled in the art that all or some of the operations of the methods, functional modules/units in the system, apparatus disclosed above may be implemented as software (which may be implemented as computer program code to be executed by a computing device), firmware, hardware, or any suitable combination thereof. In a hardware implementation, the division between functional modules/units mentioned in the above description does not necessarily correspond to the division of physical components; for example, one physical component may have multiple functions, or one function or operation may be performed by several physical components in cooperation. Some or all of the physical components may be implemented as software to be executed by a processor, such as a central processing unit, digital signal processor, or microprocessor, or implemented as hardware, or an integrated circuit, such as an application specific integrated circuit.

In addition, as is well known to a person skilled in the art, a communication medium typically embodies computer readable instructions, data structures, computer program modules or other data in a modulated data signal such as a carrier wave or other transport mechanism and includes any information delivery medium. Thus, the present disclosure is not limited to any specific combination of hardware and software.

The foregoing is a more detailed description of the present disclosure, and the specific implementations of the present disclosure are not to be considered to be limited to these descriptions. Numerous other and further simplifications or substitutions will be apparent to a person skilled in the art from the present disclosure without departing from the concept of the present disclosure, and will be considered within the protection scope of the present disclosure.

## Claims

1. A fault processing method, comprising:
analyzing historical data of each optical module according to a type of the optical module, and determining the historical data, which suddenly changes in response to a fault occurring, of the optical module;
extracting corresponding original fault data from the historical data which suddenly changes; and
performing fault model training to train a fault model according to the type of the optical module based on the original fault data.

2. The fault processing method of claim 1, further comprising:
before analyzing historical data of each optical module according to the type of the optical module, classifying optical modules according to types of the optical modules.

3. The fault processing method of claim 1, wherein the extracting corresponding original fault data from the historical data which suddenly changes comprises:
analyzing time points of sudden changes in a time series according to the historical data which suddenly changes;
determining the historical data with a ratio of sudden changes exceeding a preset ratio according to the time points of sudden changes; and
taking the historical data with the ratio of sudden changes exceeding the preset ratio as original fault data.

4. The fault processing method of any one of claims 1 to 3, wherein the performing fault model training to train a fault model according to the type of the optical module based on the original fault data comprises:
filtering the original fault data to obtain target fault data;
sampling the target fault data according to a normal-to-fault ratio of optical modules to obtain sampling data; and
performing model training according to the sampling data.

5. The fault processing method of claim 4, wherein the filtering the original fault data comprises:
deleting abnormal data in the original fault data; and/or
extracting data representing a timing characteristic of the optical module from the original fault data.

6. The fault processing method of claim 4, wherein the performing fault model training according to the type of the optical module comprises:
performing fault model training for different types of optical modules respectively, according to the sampling data corresponding to the different types of optical modules.

7. The fault processing method of claim 6, wherein the fault model comprises at least one of a machine learning model, a statistical model, or a deep learning model.

8. The fault processing method of any one of claims 1 to 3, further comprising:
after performing fault model training according to the type of the optical module, outputting a prediction result of fault risk of the optical module within a preset time, according to a result of the fault model training.

9. The fault processing method of claim 8, further comprising:
evaluating the prediction result of fault risk through a preset evaluation index.

10. The fault processing method of claim 9, further comprising:
collecting supplementary historical data corresponding to the optical module falsely detected and missed detected; and
in response to that the preset evaluation index reaches an updating threshold, updating the fault model according to the supplementary historical data.

11. A fault processing apparatus, comprising:
a data analysis module, configured to analyze historical data of each optical module according to a type of the optical module and determine the historical data, which suddenly changes in response to a fault occurring, of the optical module;
a fault extraction module, configured to extract corresponding original fault data from the historical data which suddenly changes; and
a model training module, configured to perform fault model training to train a fault model according to the type of the optical module based on the original fault data.

12. A network device, comprising a processor, a memory, and a communication bus, wherein
the communication bus is configured to be connected between the processor and the memory for communication; and
the processor is configured to execute at least one computer program stored in the memory to implement the fault processing method of any one of claims 1 to 10.

13. A computer readable storage medium, storing at least one computer program thereon, the at least one computer program, executed by at least one processor, causes the at least one processor to implement the fault processing method of any one of claims 1 to 10.
